# EUROPEAN PATENT APPLICATION

(11) **EP 4 687 393 A1**
(43) Date of publication of application: **04.02.2026**
(21) Application number: 25193115.0
(22) Date of filing: 31.07.2025
(51) Int. Cl.: H10B 63/10, H10N 70/20

(54) **CROSS-POINT MEMORY STRUCTURE AND METHOD OF CONSTRUCTION**

(30) Priority: 31.07.2024 US 202463677970 P
(71) Applicant: Micron Technology, Inc., Boise, ID 83716-9632 (US)
(72) Inventor: VENIGALLA, Rajasekhar, Boise, ID 83716 (US); THORUM, Matthew, Boise, ID 83716 (US); JUNTUNEN, Isaak, Meridian, ID 83646 (US)
(74) Representative: Marks & Clerk LLP

(57) **Abstract**

Memory devices, such as three-dimensional cross-point memory devices, and methods of manufacturing such devices are addressed. Some known methods for manufacturing such memory devices rely upon sacrificial materials which are at least partially exhumed during processing to complete the memory devices. Etch chemistries for removing such sacrificial materials may risk of removing or damaging materials or structures to the detriment of the process. An example method of avoiding damage to vertically extending conductive materials uses protective plugs above the conductive structures to isolate the conductive structures while other structures are exhumed.

## Description

### PRIORITY APPLICATION

This application claims the benefit of priority to U.S. Provisional Application Serial Number 63/677,970, filed July 31, 2024.

### BACKGROUND

Memory structures are semiconductor circuits that provide electronic storage of data for an associated "host" system (e.g., a processor or other logic circuitry, a computer, or other electronic device). Memory structures may be formed integral to an associated host system, or portion thereof, or may be formed independently as memory devices. Memory structures may be formed as either volatile or non-volatile memory. Of these, volatile memory requires power to maintain data, and includes devices such as, static random-access memory (SRAM), dynamic random-access memory (DRAM), or synchronous dynamic random-access memory (SDRAM), among others. Non-volatile memory can retain stored data when not powered, and includes devices such as flash memory, electrically erasable programmable ROM (EEPROM), erasable programmable ROM (EPROM), resistance variable memory, such as phase change random-access memory (PCRAM), resistive random-access memory (RRAM), or magnetoresistive random-access memory (MRAM), among others.

Host systems typically include a host processor, a first amount of main memory (e.g., often volatile memory, such as DRAM) to support the host processor, and one or more storage systems (e.g., often non-volatile memory, such as flash memory) that provide additional storage to retain data in addition to or separate from the main memory.

As the needs for have increased for memory providing larger storage capacities, and at the same time increased storage efficiency (storage capacity per spatial area), memory structures having multiple layers of memory cells forming a three-dimensional ("3D") array of memory cells (also termed herein a "memory array") have become increasingly common. Various forms of memory, including, for example, both non-volatile memory, such as flash, and volatile memory, such as DRAM, have been implemented as 3D memory structures.

Another configuration of memory, however, known generally as cross-point memory structures, have become desirable due to potentially relatively simpler manufacturing and greater storage efficiency. For avoidance of doubt, the referenced cross-point memory structures, are not to be confused with "X-point^{®}" memory, which is a registered trademark of Intel corporation associated with a specific cross-point memory technology.

Cross-point memory includes an array of multiple word lines extending generally within multiple first planes, the word lines typically extending generally parallel to one another in a first direction, and an array of multiple bit lines extending generally within multiple second planes, the multiple bit lines generally intersecting with the first planes of word lines (and in most cases extending generally orthogonal to the first planes of word lines). Proximate the general intersection of a word line with a bit line, there may typically be a discrete programmable element having a variable property associated with an electrical state which, in a single bit memory cell is indicative of a 1 or 0, or in a multiple bit memory cell is indicative of one of more than two electrical states, indicating one of multiple possible bits.

Some methods of manufacture of cross-point memory arrays involve use of sacrificial placeholder materials that will be removed at one or more stages during formation of the memory arrays. In many applications, removal (exhumation) of these placeholder materials can be challenging due to potential damage to other structures of the memory array. Such damage may impair the yield of fully functioning memory devices at time of manufacture, or may impair the function or reliability of completed memory arrays. Thus, it is important to minimize such potential damage during the manufacturing process.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
Figure 1 depicts a schematic of an example configuration for a planar cross-point memory array.
Figures 2A-2C depicts layout representations of cross-point memory arrays, in which Figure 2A depicts an example memory array from a top view; while Figures 2B-2C depicts the example memory array from common side views.
Figures 3A-3B depict a multi-tier structure of an example structure suitable for use in forming a three-dimensional cross-point memory array; depicted in Figure 3A from a side view, and depicted in Figure 3B from a top view, and after initial processing.
Figures 4A-4C each depict example representative stages during an example process flow.
Figures 5A-5B depict successive representative stages of a process flow which may be problematic as to potential damage to structures in the memory during removal of placeholder material.
Figures 6A-6D depict, in vertical section, respective stages of an alternative process flow for forming a memory array, configured to protect structures otherwise subject to damage during removal of placeholder material.
Figure 7 is a flowchart identifying a method for forming structures of a memory array generally in accordance with the individual stages of Figures 6A-6D.

### DETAILED DESCRIPTION

This specification addresses multiple memory structures which may be implemented in discrete memory devices (individually packaged, or packaged as a multichip device), or in one or more memory arrays implemented on a wafer (or portion thereof) comprising, for example, non-memory related structures and circuitry. Unless indicated otherwise by context, the terms "memory structures" and "memory devices" are used interchangeably with respect to the described structures, wherever the structures may be implemented.

In 3D memory structures, as noted above, memory cells are typically located in different levels, for example memory layers or tiers. These memory layers or tiers are separated from one another by separation layers or tiers, which in many examples are formed of primarily of one or more dielectric materials, which facilitates the memory cells being formed in contact with the dielectric separation layers or tiers, which for intermediate memory tiers sandwich the memory cell tiers.

In the described cross-point memory devices, each memory cell includes a configurable memory element which may be programmed to one of multiple physical states associated with a respective electrical (or other) property, and therefore associated with a data state. For purposes of the present example, the described configurable memory elements are variable resistance state memory elements in which different resistance states of the memory cell represent respective data states. For purposes of the present examples, the variable state memory elements will be described in the context of materials which exhibit variable electrical resistance associated with different physical states, and thus will be discussed in the present examples as variable resistance memory cells. Example variable resistance memory cells are described as including a chalcogenide variable resistance memory material as the configurable memory element. As known to persons skilled in the art, chalcogenides are combinations or alloys of certain materials, commonly including combinations of two or more of selenium (Se), tellurium (Te), arsenic (As), antimony (Sb), carbon (C), germanium (Ge), silicon (Si), and/or indium (In). In some examples, chalcogenide material by include additional elements such as one or more of hydrogen (H), oxygen (O), nitrogen (N), chlorine (CI), or fluorine (F), in either atomic or molecular form. Notwithstanding the description of variable resistance memory cells in the present examples, other forms of variable state memory cells, may exhibit different measurable electrical properties, or other properties (magnetism, spin, quantum properties), in the present description expressly contemplates use of such other forms of variable state memory cells.

As is known to persons skilled in the art, chalcogenide elements are known for use in phase change memory elements, in which a physical phase change may be induced in the chalcogenide element. For example, chalcogenide-containing elements may change between a relatively amorphous - disordered - state, and a relatively crystalline - ordered - state. In some examples, these physical phase states may be characterized by different resistive properties, such that measurement of the resistance across the chalcogenide elements identifies the data state associated with the physical state of each phase change memory element. In some examples, properties of the chalcogenide-containing storage element other than electrical resistance may be measured to identify one or more data states associated with the physical state of each phase change memory element.

One desirable technique for forming such cross-point memory structures is that generally termed as a "replacement gate" method, in which a placeholder material is used during initial processing of a stacked memory structure for ease of processing to form initial structures; and then the placeholder material is selectively removed, and replaced, at least in part, by metal or metal alloy structures, such as to form, for example word lines and other conductive structures. In various processes, there may be multiple times during formation of a memory array where a sacrificial material needs to be removed while minimizing damage to structures already in place.

The present disclosure addresses methods of forming a cross-point memory structure which provide improved protection of conductive structures, such as bit lines, during the manufacturing process. Example processes for forming three-dimensional cross-point memory devices include bit lines which include conductive pillars which extend vertically through a memory array structure. Some known methods for manufacturing such memory devices rely upon sacrificial materials which are at least partially exhumed during processing to complete the memory devices, wherein removal of the sacrificial materials may risk severe damage to such conductive pillars.

Accordingly, an example method of avoiding damage to vertically extending conductive materials is described, which uses protective plugs above the conductive structures to isolate the conductive structures while other structures are exhumed. Methods such as this example, and the resulting memory structures, are believed to both improve the manufacturing yield, as well as improve the electrical integrity and performance of the completed memory structures.

In the following discussion, various structures and features of the drawings are indicated by respective reference numerals. In some cases, structures and features being referred to in later figures may be essentially the same as, or directly comparable to, structures discussed relative to prior figures. In such circumstances, for clarity and consistency of description, the reference numerals from the earlier figures will be used in the subsequent drawings.

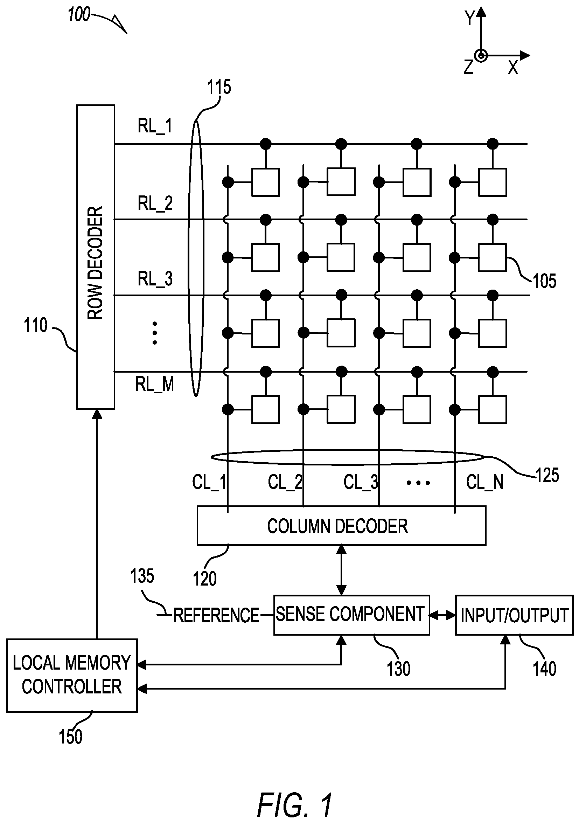

Figure 1 depicts an example configuration of a memory structure 100 including a cross-point memory array 102. Memory structure 100 includes a local memory controller 150, along with the decoding and sensing circuitry used in operating memory structure 100. Such a memory structure 100 may be implemented in a discrete memory die (or "memory chip"), as may be individually packaged, or as may be combined with other die (potentially including other memory die and/or other semiconductor die or interface devices); and may form a part of a larger microelectronic device (i.e., a computer, phone, controller, etc.). Alternatively, the memory structure 100 may be one of multiple structures formed on an individual semiconductor die or wafer, such as, in one example, cache memory formed on a semiconductor die also containing one or more processor cores, or other logic structures. In the context of the present specification, each of these example memory structures, however implemented, constitutes a "memory device."

Memory structure 100 contains multiple memory cells 105 coupled between a respective row line (RL-1, RL-2...RL-M), and a respective column line (CL-1, CL-2...CL-M). The memory cells 105 are configured to be programmable to store one of multiple logic states. In a single bit memory cell, a memory cell will be programmed to one of two possible logic states (0 or 1) to store a single bit of data. Though, as described earlier herein, in another example, in which memory cells 105 are implemented as multiple bit memory cells, each memory cell 105 will be implemented to store more than one bit of information at a time through additional logic states (00, 01, 10, 11, for example).

Memory cells 105 store the logic states through use of a configurable material within the cell (also referred to as a "memory element" or "storage element"), which is configurable to one of multiple states, each state associated with a respective logic state. For purposes of the present example, the configurable material/memory element within each of memory cells 105 may include a chalcogenide alloy as discussed above, to form a phase change memory cell. For purposes of the present examples, such a phase change memory cell may be placed in one of multiple possible phase states, each phase state associated with a logic state, as described above. For purposes of the present example, each phase state may be determined by an electrical measurement, for example, a resistivity measurement of the memory element, to identify the phase state, and thus the logic state. In some examples, a logic 0 may be indicated by the memory element in a RESET state (for example, a relatively amorphous, disordered state), and a logic 1 may be indicated by the memory in a SET state (for example, a relatively crystalline, ordered state). In some systems, additional phase states may be achievable, and may be used to identify one or more additional logic states. Additionally, other properties may be measured in place of resistivity, to determine a logic phase state of the memory element.

The memory array 102 may include access lines (here, row lines 115, extending along an illustrative x-direction; and column lines 125, each extending along an illustrative y-direction), arranged in a pattern, such as a grid-like pattern. Access lines may be formed with one or more conductive materials. In some examples, row lines 115 (RL_1, RL_2 to RL_M. etc.), or some portion thereof, may be referred to as word lines. In some examples, column lines 125 (CL-1, CL_2 to CL_N, etc.), or some portion thereof, may be referred to as digit lines or bit lines. Such word lines extend in first planes, and in a first direction, and each word line extends to respective first pluralities of memory cells in a respective memory tier; while the bit lines extend within second planes and in a second direction, and extends to respective second pluralities of memory cells distributed across multiple memory tiers; such that each word line extends proximate multiple bit lines, and that each bit line extends proximate multiple word lines.

Memory cells 105 may be positioned at proximity intersections of access lines, such as row lines 115 and the column lines 125. In some examples, memory cells 105 may also be arranged (e.g., addressed) along an illustrative z-direction, such as in an implementation of sets of memory cells 105 being located at different levels (e.g., layers, decks, planes, tiers) along the illustrative z-direction. In some examples, a memory structure 100that includes memory cells 105 at different levels may be supported by a different configuration of access lines, decoders, and other supporting circuitry than shown.

Operations such as read operations and write operations may be performed on the memory cells 105 by activating access lines such as one or more of a row line 115 or a column line 125, among other access lines associated with alternative configurations. For example, by activating a row line 115 and/or a column line 125 (e.g., applying a voltage to the row line 115 or the column line 125), a memory cell 105 may be accessed in accordance with their proximity intersection. An intersection of a row line 115 and a column line 125, among other access lines, in various two-dimensional or three-dimensional configuration may be referred to as an address of a memory cell 105. In some examples, an access line may be a conductive line coupled with a memory cell 105 and may be used to perform access operations on the memory cell 105. In some examples, the memory structure 100 may perform operations responsive to commands, which may be issued by a host device coupled with the memory structure 100 or may be generated by the memory structure 100 (e.g., by a local memory controller 150).

During a write operation (e.g., a programming operation) of a self-selecting or thresholding memory cell 105, a polarity used for a write operation may influence (e.g., determine, set, or program) a behavior or characteristic of the material of the memory cell 105, such as a thresholding characteristic (e.g., a threshold voltage) of the material. A difference between thresholding characteristics of the material of the memory cell 105 for different logic states stored by the material of the memory cell 105 (e.g., a difference between threshold voltages when the material is storing a logic state '0' versus a logic state '1') may correspond to a read window of the memory cell 105).

Accessing the memory cells 105 may be controlled through one or more decoders, such as a row decoder 110 or a column decoder 120, among other examples. For example, a row decoder 110 may receive a row address from the local memory controller 150 and activate a row line 115 based on the received row address. A column decoder 120 may receive a column address from the local memory controller 150 and may activate a column line 125 based on the received column address.

The sense component 130 may be operable to detect a state (e.g., a material state, a resistance state, a threshold state) of a memory cell 105 and determine a logic state of the memory cell 105 based on the detected state. The sense component 130 may include one or more sense amplifiers to convert (e.g., amplify) a signal resulting from accessing the memory cell 105 (e.g., a signal of a column line 125 or other access line). The sense component 130 may compare a signal detected from the memory cell 105 to a reference 135 (e.g., a reference voltage, a reference charge, a reference current). The detected logic state of the memory cell 105 may be provided as an output of the sense component 130 (e.g., to an input/output component 140), and may indicate the detected logic state to another component of the memory structure 100 or to a host device coupled with the memory structure 100.

The local memory controller 150 may control the accessing of memory cells 105 through the various components (e.g., a row decoder 110, a column decoder 120, a sense component 130, among other components). In some examples, one or more of a row decoder 110, a column decoder 120, and a sense component 130 may be co-located with the local memory controller 150. The local memory controller 150 may be operable to receive information (e.g., commands, data) from one or more different controllers (e.g., an external memory controller associated with a host device, another controller associated with the memory structure 100), translate the information into a signaling that can be used by the memory structure 100, perform one or more operations on the memory cells 105 and communicate data from the memory structure 100 to a host device based on performing the one or more operations. The local memory controller 150 may generate row address signals and column address signals to activate access lines such as a target row line 115 and a target column line 125. The local memory controller 150 also may generate and control various signals (e.g., voltages, currents) used during the operation of the memory structure 100. In general, the amplitude, the shape, or the duration of an applied signal discussed herein may be varied and may be different for the various operations discussed in operating the memory structure 100.

The local memory controller 150 may be operable to perform one or more access operations on one or more memory cells 105 of the memory structure 100. Examples of access operations may include a write operation, a read operation, a refresh operation, a precharge operation, or an activate operation, among others. In some examples, access operations may be performed by or otherwise coordinated by the local memory controller 150 in response to access commands (e.g., from a host device). The local memory controller 150 may be operable to perform other access operations not listed here or other operations related to the operating of the memory structure 100 that are not directly related to accessing the memory cells 105.

As discussed above, in some examples, example memory structure 100 may include a memory array 102 of memory cells 105 arranged in a three-dimensional architecture that includes memory cells 105 arranged according to different levels (e.g., layers, decks, tiers). For example, vertically offset levels of memory cells 105 may be separated by intervening levels of dielectric materials such that the memory cells 105 are formed in contact with the dielectric material levels.

The memory structure 100 may include any quantity of non-transitory computer-readable media that support memory cell protective layers in a three-dimensional memory array. For example, a local memory controller 150, a row decoder 110, a column decoder 120, a sense component 130, or an input/output component 140, or any combination thereof may include or may access one or more non-transitory computer-readable media storing instructions (e.g., firmware) for performing the functions ascribed herein to the memory structure 100. For example, such instructions, if executed by the memory structure 100, may cause the memory structure 100 to perform one or more associated functions as described herein.

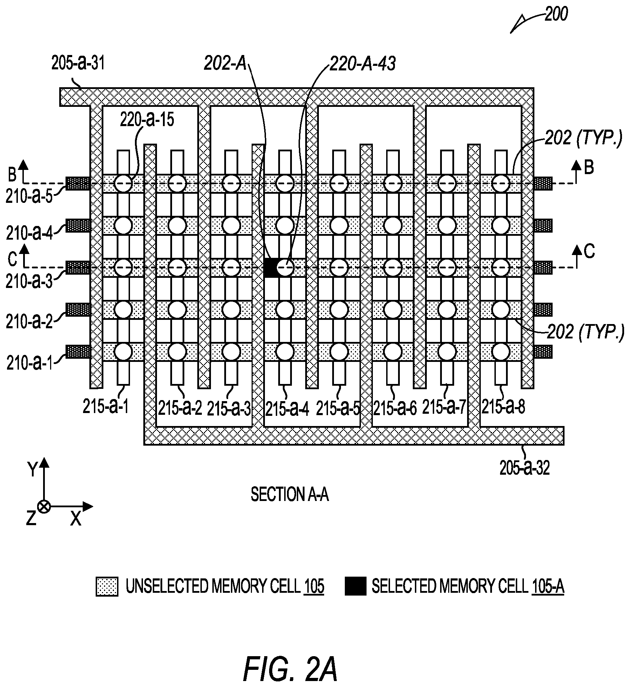

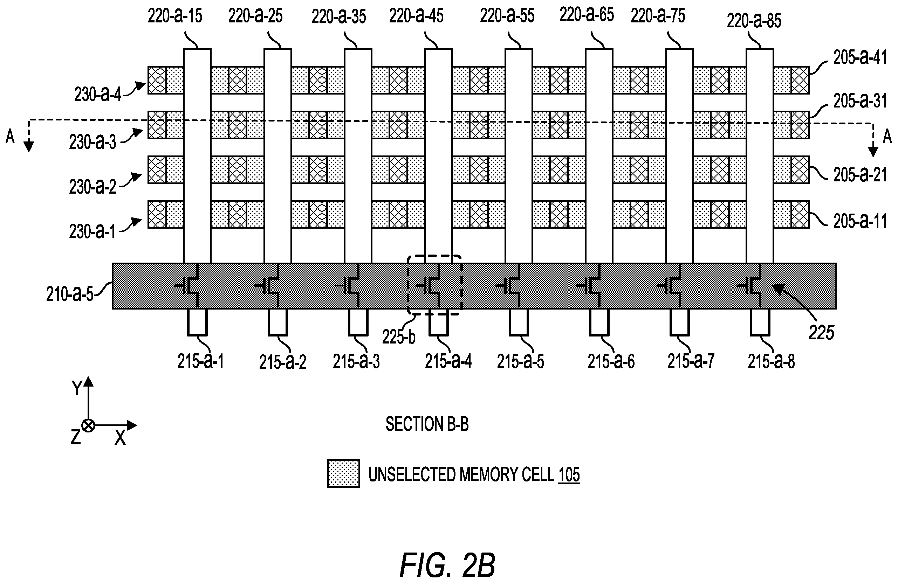

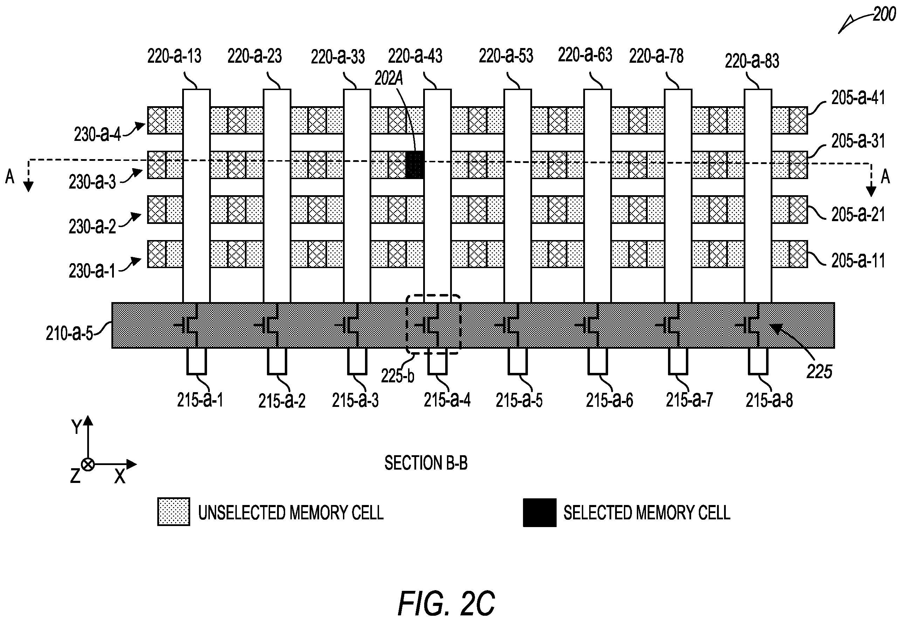

Referring now to Figures 2A-2C, the Figures depict an example memory array 200 that supports memory cell layers in a three-dimensional memory array in accordance with examples as disclosed herein. The memory array 200 may be included in a memory structure 100, and illustrates an example of a three-dimensional arrangement of cross-point memory cells 202 that may be accessed by various conductive structures (e.g., access lines). Figure 2A depicts a top section view (e.g., Section A-A) of the memory array 200 relative to a cut plane A-A as shown in Figures 2B and 2C. Figure 2B illustrates a side section view (e.g., Section B-B) of the memory array 200 relative to a cut plane B-B as shown in Figure 2A. Figure 2C illustrates a side section view (e.g., Section C-C) of the memory array 200 relative to a cut plane C-C as shown in Figure 2A. The section views provide hope and examples of cross-sectional views of the memory array 200 with some aspects (e.g., dielectric structures) removed for clarity. Elements of the memory array 200 may be described relative to an x-direction, a y-direction, and a z-direction, as illustrated in each of Figures 2A, 2B, and 2C. Although some elements included in Figures 2A, 2B, and 2C are labeled with a numeric indicator, other corresponding elements are not labeled, although they are the same or would be understood to be similar, in an effort to increase visibility and clarity of the depicted features. Further, although some quantities of repeated elements are shown in the illustrative example of memory array 200, techniques in accordance with examples as described herein may be applicable to any quantity of such elements, or ratios of quantities between one repeated element and another.

In the example of memory array 200, memory cells 202 and word lines 205 may be distributed along the z-direction according to levels 230 (e.g., layers, planes, tiers, as illustrated in Figures 2B and 2C). In some examples, the z-direction may be orthogonal to a substrate (not shown) of the memory array 200, which may be below the illustrated structures along the z-direction. Although the illustrative example of memory array 200 includes four levels 230, a memory array 200 in accordance with examples as disclosed herein may include any quantity of one or more levels 230 (e.g., 64 levels, 128 levels, and greater) along the z-direction.

Each word line 205 may be an example of a portion of an access line that is formed by one or more conductive materials (e.g., one or more metal portions, one or more metal alloy portions). As illustrated, a word line 205 may be formed in a comb structure, including portions (e.g., projections, tines) extending along the y-direction through gaps (e.g., alternating gaps) between pillars 220. For example, as illustrated, the memory array 200, may include two word lines 205 per level 230 (e.g., according to odd word lines 205-a-n1 and even word lines 205-a-n2 for a given level, n), where such word lines 205 of the same level 230 may be described as being interleaved (e.g., with portions of an odd word line 205-a-n1 projecting along the y-direction between portions of an even word line 205-a-n2, and vice versa). In some examples, an odd word line 205 (e.g., of a level 230) may be associated with a first memory cell 202 on a first side (e.g., along the x-direction) of a given pillar 220 and an even word line (e.g., of the same level 230) may be associated with a second memory cell 202 on a second side (e.g., along the x-direction, opposite the first memory cell 202) of the given pillar 220. Thus, in some examples, memory cells 202 of a given level 230 may be addressed (e.g., selected, activated) in accordance with an even word line 205 or an odd word line 205.

Each pillar 220 may be an example of a portion of an access line (e.g., a conductive pillar portion) that is formed by one or more conductive materials (e.g., one or more metal portions, one or more metal alloy portions). As illustrated, the pillars 220 may be arranged in a two-dimensional array (e.g., in an x-y plane) having a first quantity of pillars 220 along a first direction (e.g., eight pillars along the x-direction, eight rows of pillars), and having a second quantity of pillars 220 along a second direction (e.g., five pillars along the y-direction, five columns of pillars). Although the illustrative example of memory array 200 includes a two-dimensional arrangement of eight pillars 220 along the x-direction and five pillars 220 along the y-direction, a memory array 200 in accordance with examples as disclosed herein may include any quantity of pillars 220 along the x-direction and any quantity of pillars 220 along the y-direction. Further, as illustrated, each pillar 220 may be coupled with a respective set of memory cells 202 (e.g., along the z-direction, one or more will memory cells 202 for each level 230). A pillar 220 that extends along the z-direction may have a cross-sectional area in an x-y plane. Although illustrated with a circular cross-sectional area in the x-y plane, a pillar 220 may be formed with a different shape, such as having an elliptical, square, rectangular, polygonal, or other cross-sectional area in an x-y plane.

The memory cells 202 each may include a chalcogenide material. In some examples, the memory cells 202 may be examples of thresholding memory cells. Each memory cell 202 may be accessed (e.g., addressed, selected) according to a proximate intersection between a word line 205 (e.g., a level selection, which may include an even or odd selection within a level 230) and a pillar 220 at the memory element. For example, as illustrated, a selected memory cell 202-a of the level 230-a-3 may be accessed according to such a proximate intersection between the pillar 220-a-43 and the word line 205-a-32.

A memory cell 202 may be accessed (e.g., written to, read from) by applying an access bias (e.g., an access voltage, Vaccess, which may be a positive voltage or a negative voltage) across the memory cell 202. In some examples, an access bias may be applied by biasing a selected word line 205 with a first voltage (e.g., Vaccess/2) and by biasing a selected pillar 220 with a second voltage (e.g., - Vaccess/2), which may have an opposite sign relative to the first voltage. Regarding the selected memory cell 202-a, a corresponding access bias (e.g., the first voltage) may be applied to the word line 205-a-32, while other unselected word lines 205 may be grounded (e.g., biased to 0V). In some examples, a word line bias may be provided by a word line driver (not shown) coupled with one or more of the word lines 205.

To apply a corresponding access bias (e.g., the second voltage) to a pillar 220, the pillars 220 may be configured to be selectively coupled with a sense line 215 (e.g., a digit line, a column line, an access line extending along the y-direction) via a respective transistor 225 coupled between (e.g., physically, electrically) the pillar 220 and the sense line 215. In some examples, the transistors 225 may be vertical transistors (e.g., transistors having a channel along the z-direction, transistors having a semiconductor junction along the z-direction), which may be formed above the substrate of the memory array 200 using various techniques (e.g., thin film techniques). In some examples, a selected pillar 220, a selected sense line 215, or a combination thereof may be an example of a selected column line 125 described with reference to Figure 1 (e.g., a bit line).

The transistors 225 (e.g., a channel portion of the transistors 225) may be activated by gate lines 210 (e.g., activation lines, selection lines, a row line, an access line extending along the x-direction) coupled with respective gates of a set of the transistors 225 (e.g., a set along the x-direction). In other words, each of the pillars 220 may have a first end (e.g., towards the negative z-direction, a bottom end) configured for coupling with an access line (e.g., a sense line 215). In some examples, the gate lines 210, the transistors 225, or both may be considered to be components of a row decoder 110 (e.g., as pillar decoder components). In some examples, the selection of (e.g., biasing of) pillars 220, or sense lines 215, or various combinations thereof, may be supported by a column decoder 120, or a sense component 130, or both.

To apply the corresponding access bias (e.g., -Vaccess/2) to the pillar 220-a-43, the sense line 215-a-4 may be biased with the access bias, and the gate line 210-a-3 may be grounded (e.g., biased to 0V) or otherwise biased with an activation voltage. In an example where the transistors 225 are n-type transistors, the gate line 210-a-3 being biased with a voltage that is relatively higher than the sense line 215-a-4 may activate the transistor 225-a (e.g., cause the transistor 225-a to operate in a conducting state), thereby coupling the pillar 220-a-43 with the sense line 215-a-4 and biasing the pillar 220-a-43 with the associated access bias. However, the transistors 225 may include different channel types, or may be operated in accordance with different biasing schemes, to support various access operations.

In some examples, unselected pillars 220 of the memory array 200 may be electrically floating when the transistor 225-a is activated, or may be coupled with another voltage source (e.g., grounded, via a high-resistance path, via a leakage path) to avoid a voltage drift of the pillars 220. For example, a ground voltage being applied to the gate line 210-a-3 may not activate other transistors coupled with the gate line 210-a-3, because the ground voltage of the gate line 210-a-3 may not be greater than the voltage of the other sense lines 215 (e.g., which may be biased with a ground voltage or may be floating). Further, other unselected gate lines 210, including gate line 210-a-5 as shown in Figure 2B, may be biased with a voltage equal to or similar to an access bias (e.g., -Vaccess/2, or some other negative bias or bias relatively near the access bias voltage), such that transistors 225 along an unselected gate line 210 are not activated. Thus, the transistor 225-b coupled with the gate line 210-a-5 may be deactivated (e.g., operating in a non-conductive state), thereby isolating the voltage of the sense line 215-a-4 from the pillar 220-a-45, among other pillars 220.

In a write operation, a memory cell 202 may be written to by applying a write bias (e.g., where Vaccess = Vwrite, which may be a positive voltage or a negative voltage) across the memory cell 202. In some examples, a polarity of a write bias may influence (e.g., determine, set, program) a behavior or characteristic of the material of the memory cell 202, such as the threshold voltage of the material. For example, applying a write bias with a first polarity may set the material of the memory cell 202 with a first threshold voltage, which may be associated with storing a logic 0. Further, applying a write bias with a second polarity (e.g., opposite the first polarity) may set the material of the memory cell with a second threshold voltage, which may be associated with storing a logic 1. A difference between threshold voltages of the material of the memory cell 202 for different logic states stored by the material of the memory cell 202 (e.g., a difference between threshold voltages when the material is storing a logic state '0' versus a logic state '1') may correspond to the read window of the memory cell 202.

In a read operation, a memory cell 202 may be read from by applying a read bias (e.g., where Vaccess = Vread, which may be a positive voltage or a negative voltage) across the memory cell 202. In some examples, a logic state of the memory cell 202 may be evaluated based on whether the memory cell 202 thresholds in the presence of the applied read bias. For example, such a read bias may cause a memory cell 202 storing a first logic state (e.g., a logic 0) to threshold (e.g., permit a current flow, permit a current above a threshold current), and may not cause a memory cell 202 storing a second logic state (e.g., a logic 1) to threshold (e.g., may not permit a current flow, may permit a current below a threshold current).

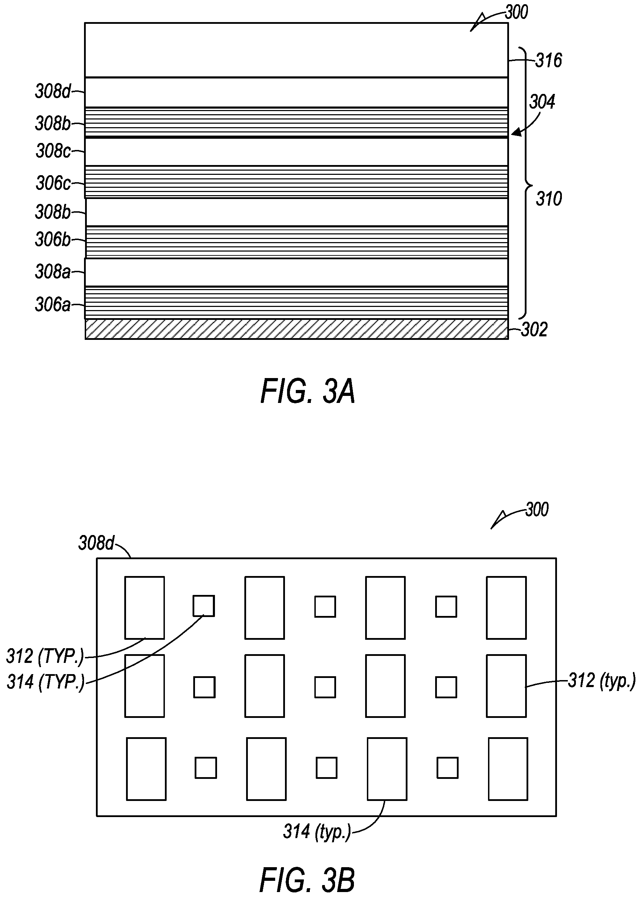

Figures 3A-3B depicts an example multi-tier memory structure 300 which may be formed and used as an initial structure from which the example structures of the remaining Figures are formed. Multi-tier memory structure 300 is formed on a substrate 302, which in many cases will be a semiconductor substrate, for example a silicon substrate. Though in some examples, substrate 302 may be formed of another material, for example a glass or ceramic material, which supports either directly or indirectly (through intervening materials) the semiconductor material tier. Multi-tier memory structure 300 includes an alternating stack structure forming the memory array portion 304 of the memory structure (after later processing), as described herein).

Structures used in forming the memory array portion 304 of memory structure 300 may be formed directly on the substrate 302 or above one or more levels of material extending over a surface of the substrate (not depicted). The memory array portion 304 (also termed herein, "memory array"), includes a stacked tier structure 310 which includes a stack of multiple alternating tiers of different material compositions. In many cases, a first set of dielectric tiers 306 (identified as 306a - 306d) will include a first dielectric material to facilitate forming conductive structures alternating in between the dielectric tiers 306; as such the dielectric tiers may also be considered as spacer or separation tiers. In many examples the dielectric tiers 306 of the alternating tiers will comprise one or more oxides. Alternating with the dielectric tiers are the second set of tiers 308, termed herein "memory tiers," as further described below. In the present example, these memory tiers 308 will initially include a placeholder material which may be selectively removed relative to the material of the first set of dielectric tiers 306. The stack structure includes a capping tier 316 at the top. Capping tier 316 will be a dielectric, and will be discussed in more detail later herein.

For purposes of the present examples, construction of the memory array portion 304 will be accomplished through use of a technique broadly described as a "replacement gate" processing, in which various structures of the memory array will be constructed with the initial material of the second set of tiers 308 being a placeholder material. And at a later stage of processing, that placeholder material will be removed, at least in part, and replaced with a replacement gate material, commonly a metal or metal alloy, a significant portion of which will form word lines of the memory array. The memory tiers 308 will ultimately contain other materials forming bodies of memory cells, and thus for purposes of this illustration, for a convenient term to provide clarity of explanation, the second set of alternating tiers 308 between the tiers of dielectric material are termed in the present description "memory tiers," addressing the location and ultimate function of the tier, regardless of whether that location is occupied by the initial placeholder material or by the later-placed replacement gate material.

The dielectric tiers 306 facilitate the memory cells being formed in contact with the dielectric tiers 306, which for intermediate memory tiers sandwich the memory tiers. For purposes of the present example, the dielectric tiers 306 will be described as formed of oxide. And in such examples, the initial placeholder material of the memory tiers 308 may commonly be a nitride of a composition selectively removable relative to the selected oxide of the tiers 306.

In the present examples, only a limited number of vertically alternating dielectric tiers 306 and memory tiers 308 are depicted, for clarity. Persons skilled in the art will recognize that a much greater number of such alternating tiers will typically be present in a commercial memory structure. For example, in various types of 3D memory structures, hundreds of memory tiers 308, and accompanying dielectric tiers 306, may be present. As persons skilled in the art will recognize, in some examples, memory tiers may be formed in vertically arranged groups (commonly termed "decks") which interconnect to form the memory array.

Once the stacked tier structure 310 has been formed to a desired number of alternating memory tiers and dielectric tiers (as in Figure 3A), openings will be formed in the tiers for forming, and for accommodating, other structures of the memory array. In the depicted example, multiple pier openings 312 have been formed extending through at least a portion of the stacked tier structure 310; and multiple pillar openings 314 have been formed extending through a respective portion of the stacked tier structure (which may in some examples be the same portion is that through which the pier openings 312 extend).

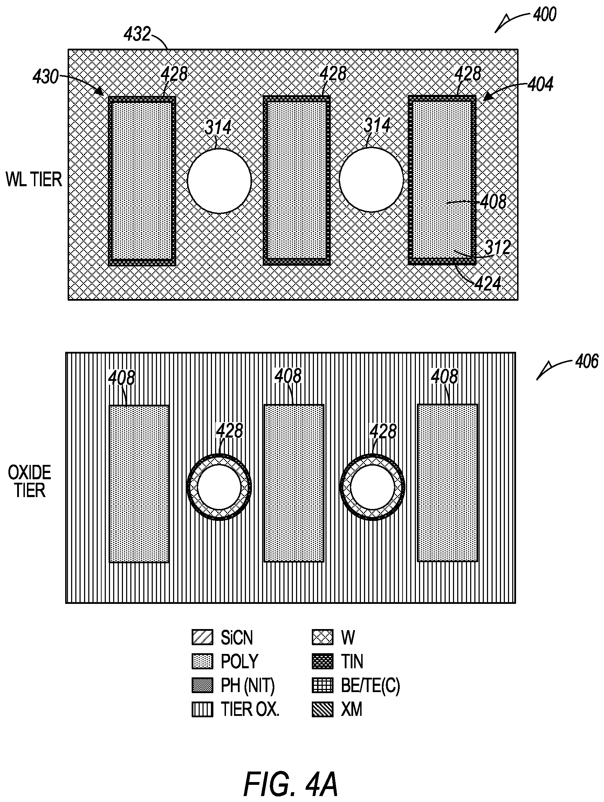

Figures 4A-4C depict representative stages of an example manufacturing process flow. The stages of these Figures follow from the stacked tier structure 310 of Figure 3A. The representative stages of each Figure include two portions, an upper plan view of a representative memory tier (also termed a "word line" tier, abbreviated "WL Tier"), indicated generally at 404, and a lower plan view of a representative dielectric tier, indicated generally at 406, as will be vertically adjacent to at least one respective memory tier 404. For avoidance of doubt, the various stages of the process flow are represented by formation of memory cell structures to each side of a central pier, and extending to adjacent piers to each side of the central pier. Although not depicted in the representative stages, it should be understood that the same types of memory cell structures are also being formed on both sides of all piers aligned along the word line direction; and thus, the same memory cell structures are being constructed beyond the outermost piers in the depiction of each stage. As depicted in Figure 3A, the initial stacked tier structure includes an alternating series of pier openings and pillar openings along the word line direction, and the pattern of memory cell formation similarly repeats along the word line direction.

For the avoidance of doubt, the term "adjacent" is used herein to identify structures or materials which are near to one another (within the dimensional scale of dimensions of structures, thickness of material layers, etc.), though not necessarily in physical contact with one another (as they may be separated by a material layer, for example). In the case of repeating structures that will be described, such as piers and pillars, which are in spaced relation to one another throughout the memory array, the term "adjacent" is used to identify that the two structures (piers, for example) are the neighboring structures (i.e., two piers are "adjacent" to one another along a first access, when there is no other pier along the first axis between the two piers along that first axis).

As depicted in Figure 4A, the tiers are depicted at a replacement gate metallization stage. Relative to stacked tier structure 310 of Figure 3A, the pier openings 312 have been filled with suitable pier fill material 408 to form piers 420 in contact with the stacked structure surfaces defining pier openings 312. For purposes of the present example the pier fill material 408 may commonly be polysilicon, or in other examples may be a dielectric material, or may comprise multiple materials, one or more of which may be a dielectric material. In some embodiments a liner may be formed around the entire pier, or around portions thereof (such as portions extending through the memory tiers).

In certain examples, the pier fill material 408 may be the same for all piers; however, in other examples, a first group of piers may have a first primary fill material such as that described above; while selected piers may have a different fill material, for example in response to placement of the selected piers proximate structures of the memory array to be formed later, in which cases the different fill material may be selected to facilitate later processing, such as potentially exhuming only the selected piers.

In the present example, after pier openings 312 are formed, and filled with pier fill material 408 forming piers 420, then pillar openings 314 are formed. Pillar openings 314 will ultimately contain respective conductive pillars serving as portions of bit lines of the memory array 402. As a result, in many examples, pillar openings 314 may commonly extend to intersect a respective conductive material structure formed beneath the stacked tier structure, but above the substrate, forming a portion of respective memory array bitlines. In some examples, the pier fill material 408 may be a single material, such as polysilicon, silicon carbon nitride (SiCN), amorphous silicon ,or other material that functions well as a sacrificial material in view of the chemistries used in manufacturing the memory array; or in other examples, may be a composite, comprising a first material for example as a liner within the pier openings 312, with another pier fill material (such as the above) within the liner.

Figure 4A further reflects additional processing, including, replacement gate metallization, which includes exhuming at least a portion of the first placeholder material in the memory tiers 308 through use of the pillar openings 314. Exhuming of the first placeholder material will form voids defined by exposed dielectric material tier surfaces and first surfaces of the piers extending between the dielectric material tiers. As identified previously, the placeholder material 412 in the memory tiers 308 may be a nitride. For example, surfaces of piers 420 extending between dielectric tiers 306 are exposed, while leaving the dielectric tiers and the piers intact (with the exception of the previously formed pillar openings 314 extending through the dielectric tiers 306 of the stacked structure).

After at least a portion of the original placeholder material of the memory tiers 404 is exhumed, other material may be formed on the exposed portion of piers 420 extending through the vertical dimension of memory tiers 308. In the present example, conductive material, indicated generally at 426, such as titanium nitride (TiN), may be deposited through pillar openings 314 and etched back to a titanium nitride layer 428 In the completed memory array, titanium nitride layer 428 may serve as a liner to later-formed word lines (432). After formation of titanium nitride layer 428, the conductive word line material 430 is deposited in the memory tier 404 and etched back to define the word lines 432 in memory tiers 404. In the present example, word line material 430 may be tungsten, or another material having comparable conductivity and mechanical properties.

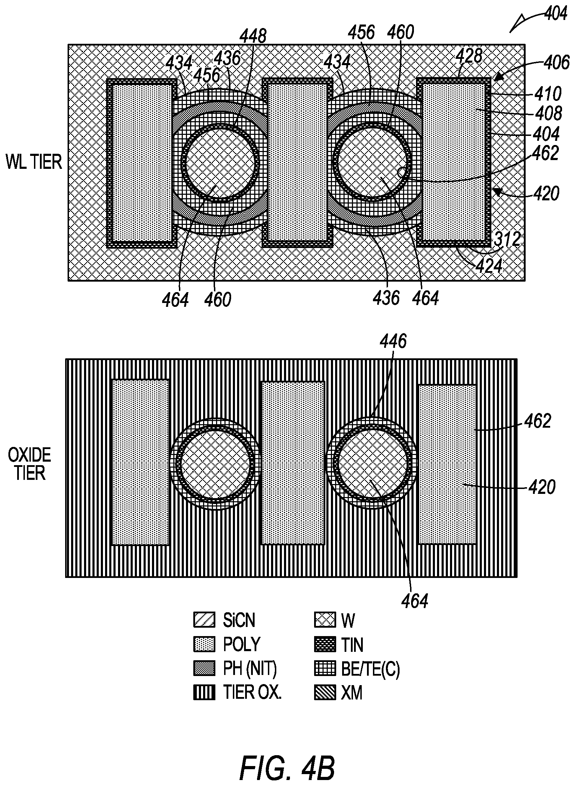

Figure 4B depicts the structure of Figure 4A wherein a substantial portion of the memory cell structure has been formed. After recessing of the tungsten word line material 430 and the titanium nitride barrier layer 424, the pillar openings 314 in the word line layers have been enlarged by recessing the titanium nitride and the word lines to form partially circular memory cell recesses 434 between respective pairs of piers for housing structures of respective memory cells. In the depicted example, the memory cell recesses 434 are curvilinear in a horizontal plane (as viewed from above as in Figures 4A-4C); and later-formed structures within the recesses, such as first electrodes 436, placeholder material 456, and second electrodes 460 will similarly be curvilinear within that horizontal plane.

In the present example, these curvilinear components are placed generally concentric to one another by deposition and etch back processes through the pillar openings 314; and include respective first electrodes 436, placeholder material 456, and second electrodes 460 within the respective partially circular recesses 434. Subsequently, the generally vertically extending tungsten pillars 438 of the bit lines are formed within the remaining pillar openings 314. In many examples, a titanium nitride liner will be formed in the pillar openings 31 after forming of the second electrode(s) 460, to serve as liners for the tungsten pillars.

In the present example process flow, multiple variable resistance memory cells will be formed within memory cell units, in which the multiple memory cells have first electrodes in electrical communication with respective access lines, for example word lines; but the multiple memory cells have second electrodes in electrical communication with another access line, for example a bit line. In the present example, two memory cell units are formed on opposite sides of a central pier; and the two variable resistance memory cells of the example memory cell units are formed on, what will ultimately be, opposite sides of the conductive pillar of a bit line of each memory cell unit (in the example, in a second direction orthogonal to the word line direction); though at the time of formation of the electrodes for the two variable resistance memory cells, the electrodes for each cell will be on opposite sides of a pillar opening. The second electrodes of the memory cells within a respective memory cell unit may be formed as a unitary structure (i.e., a shared electrode of multiple memory cells). As a result, in the present example the two memory cells in each tier associated with a respective pillar are formed generally to opposite halves of the pillar.

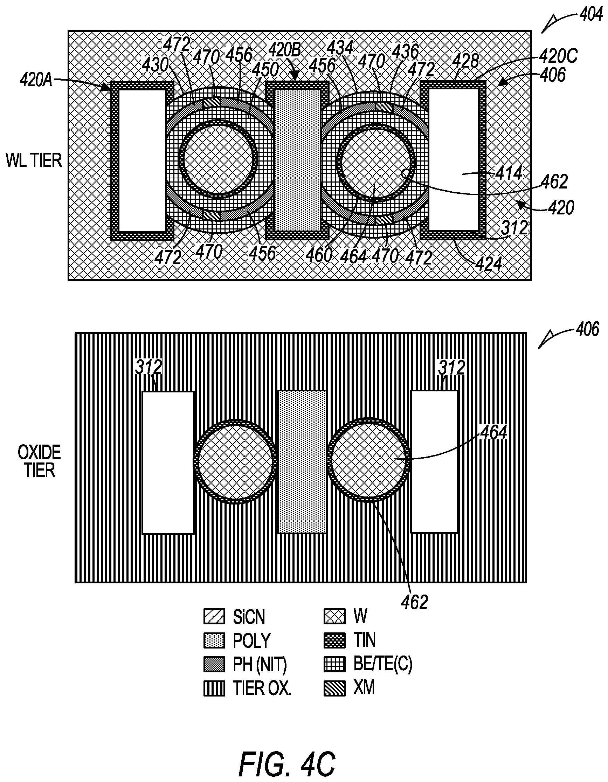

At this stage, the first portion of construction of the memory array, conducted through the pillar openings is complete, and further construction will be formed through selected pier openings 312. As a result, the processing flow as depicted in Figure 4B is at a stage immediately before exhuming of the pier fill material 408 from alternating piers along the word line direction. In the context of the depicted memory cells, pier fill material 408 is exhumed from piers 420A and 420C, while leaving central pier 420B (of these three example adjacent piers in respective pier openings 312) intact, as depicted in Figure 4C. With the exhuming of pier fill material 408 from piers 420A and 420C, placeholder material 456, between first electrodes 436 and second electrodes 460 is recessed to define respective spaces to receive a memory element material 470 (In the present example embodiment a variable resistance material such as, by way of example, a chalcogenide material). Subsequent to forming the structure depicted in Figure 4C, a placeholder material (not depicted) may be deposited in the open pier openings 312 to effectively reform piers 420A and 420C. In some examples such placeholder material 472 may extend into a portion of the space between first electrodes 436 and second electrodes 460, effectively sandwiching the memory element in the space between those electrodes. For purposes of the present example, such additional placeholder material 472 is shown in such position, though the additional placeholder material is not depicted in the pier openings 312 for piers 420A and 420C.

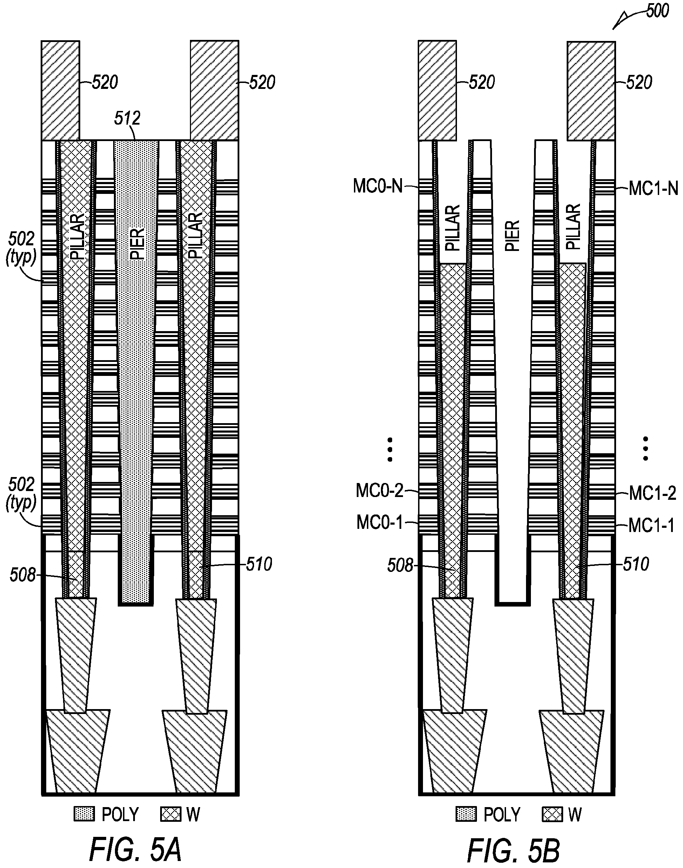

Referring now to Figures 5A-5B, the Figures depict a difficulty that can exist with currently known processing techniques for forming vertical cross-point memory arrays, with an architecture generally as described above. Figure 5A depicts a stacked memory structure 500, with multiple layers of memory tiers indicated typically at 502, alternating with dielectric tiers (indicated typically at 504), and depicted at a stage as discussed relative to Figure 4B with some structures of memory cells formed in each memory tier 502, around respective pillars 508, 510. In this vertical cross-sectional view through the center of pillars 508, 510, the structures of each memory cell, such as the example memory cells of Figures 4A-4C will be located along a Y axis, extending into and out of the page, both behind and in front of the depicted pillars 508, 510. But a memory cell unit in each memory tier 502 tier will be associated with a respective pillar (indicated as MC0-1, MC0-2 ...MC0-N adjacent pillar 508; and MC1-1, MC1-2...MC1-N) adjacent pillar 510. In examples in which the memory cells are constructed generally similar to the memory cells of Figures 4A-4C, each memory cell unit includes two memory cells adjacent a respective pillar 512 in a respective memory tier. Above the alternating memory tiers and dielectric tiers, lies a capping tier 518, which may be formed of a dielectric material resistant to etching through chemistries used for constructing the memory cells, for example of an oxide.

As described previously, an alternating pattern of piers 512 and pillars 508, 510 will extend across the memory array in a first direction, such as a word line direction, for example from left to right in Figure 5A. And in the described processing, to complete structures of the memory cells, alternate piers will be exhumed to provide access for completing the memory cells. For example, in the example of Figure 5A, depicted pier 512 will be exhumed to facilitate completion of the memory cells of each memory tier 502. Though not illustrated, immediately to the left and right of the depicted cross section would lie additional piers which would not be exhumed for completion of the memory cells of the respective memory tiers.

As can be seen in Figure 5A, the pier opening 312, and the pillar openings 314 exhibit a taper narrowing the respective openings in the direction of the lower tiers. This is a common challenge in multi-tier construction and the greater the aspect ratio of the opening, the more narrowing that typically occurs. Etch processes and chemistries are typically adapted to minimize the effect, though it is difficult to avoid in high aspect ratio openings, such as arises with 3D memory devices, particularly those with a large number of memory tiers. In order to maintain necessary feature sizes for structures formed within the openings, the upper dimensions will commonly be adjusted in view of the etch processes to facilitate important dimensions, with the result that spacing between features at the upper surface may present challenges in operation such as exhuming of piers 512 from pier openings 312.

A patterned hard mask 520 (such as an oxide hard mask), is formed above capping tier 518 and will be used to exhume the material of pier 512 (such as, in some examples, polysilicon). Ideally, hard mask 520 would fully cover pillars 508, 510, and the associated first electrodes 514 of the memory cells. However, due to the narrow spacing discussed above, and the challenges of near-perfect mask alignment, frequently pillars 508, 510 will be subject to the etch chemistry for exhuming pier 512. In many circumstances, the etch chemistry used to remove the piers (for example, polysilicon) will also remove the tungsten of the pillars 508, 510 and the associated carbon electrode 514. This can lead to recessing the pillars beneath capping tier 518 and most significantly, adjacent some upper portion of the multiple memory tiers, to where the pillar can no longer serve as a bit line from memory cells in those tiers; thereby damaging, if not irrevocably ruining, the memory array being constructed.

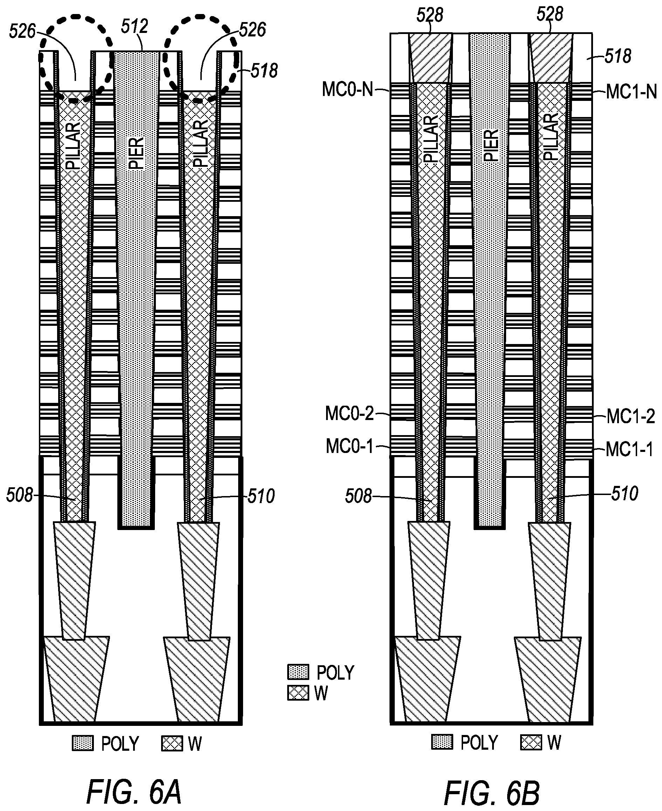

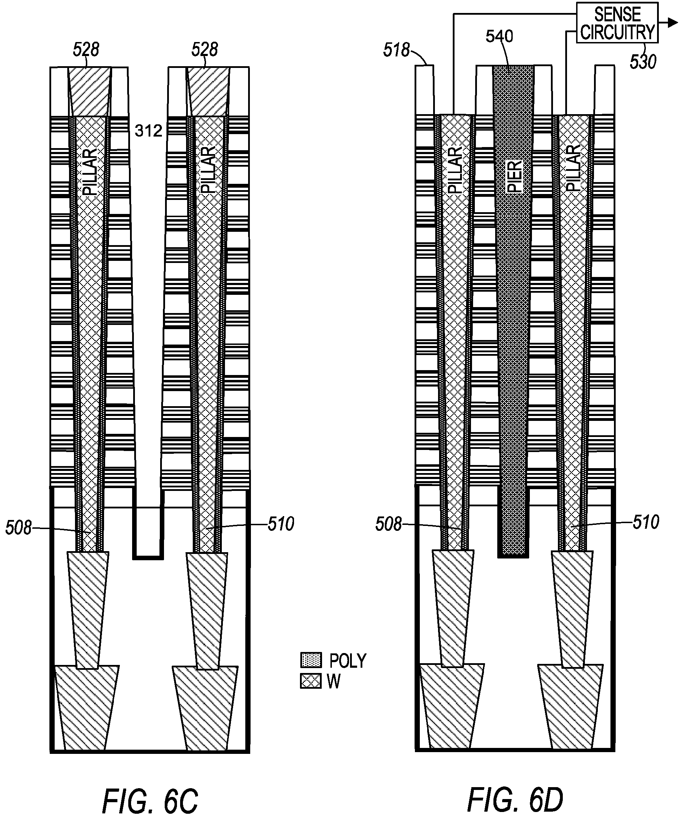

Referring now to Figures 6A-6D, the Figures depict an alternative process which addresses the deficiencies of some currently known processes, as described relative to Figures 5A-B, by facilitating exhuming of the pier 512, while preserving the integrity of pillars 508, 510. Before placing the hard mask 520, recesses 526 will be etched in capping tier 518 above pillars 508, 510, recessing the pillars, 508, 510 (and surrounding carbon electrodes) to approximately the lower surface of the capping tier 518. Where capping tier 518 is an oxide, it may be selectively removed relative to the tungsten (and carbon) of the pillars 508, 510. Recesses 526 will be filled with plugs 528 of a material resistant to the etch process used to remove the material of pier 512 (for example, polysilicon); and also to the etch processes used to remove a portion of the placeholder material 456 between the first and second electrodes to define a recess 458 for receiving variable resistance memory element material 470, and for placing the memory element material 470 within the recess. (See Figure 4C). The material of plug 528 should also preferably be one susceptible to chemical mechanical planarization (CMP). For example, the plug 528 may be oxide, hafnium oxide (HfO2), zirconium oxide (ZrO2), lanthanum oxide (La2O3) or similar materials. Once the upper surface of the capping tier 518 and the plugs 528 and been planarized through CMP, the hard mask 520 may be placed over the structure of Figure 6B in a manner analogous to that depicted in Figures 5A-5B. With the plugs over the pillars resisting the exhumation chemistry and protecting the pillars 508, 510, the pier 512 is exhumed, as depicted in Figure 6C.

After exhuming of the pier 512 in Figure 6B resulting in pier opening 532, the remaining structures of the memory cells can be formed. Specifically, referring to figure 4C the portions of the placeholder material 456 between the first electrodes 436 and second electrodes 460, and adjacent the open pier openings 312 will be recessed a select distance away from the pier openings, and memory element material will be placed in the recess, and etched back as necessary, thereby completing the structures of the memory cell. Subsequently, while the plugs 528 are still in place, the pier opening 312 may again be filled with a sealing material 540 to complete the memory array structure. Subsequently, as depicted in Figure 6D, plugs 528 will be removed, and the bit line pillars 508, 510 will be electrically connected to other circuits for operating the memory, such as sense circuitry 530. As can be seen in Figure 6C the upper surfaces of the pillars 508, 510 are at a lower level than the upper surface of the pier sealing material 540.

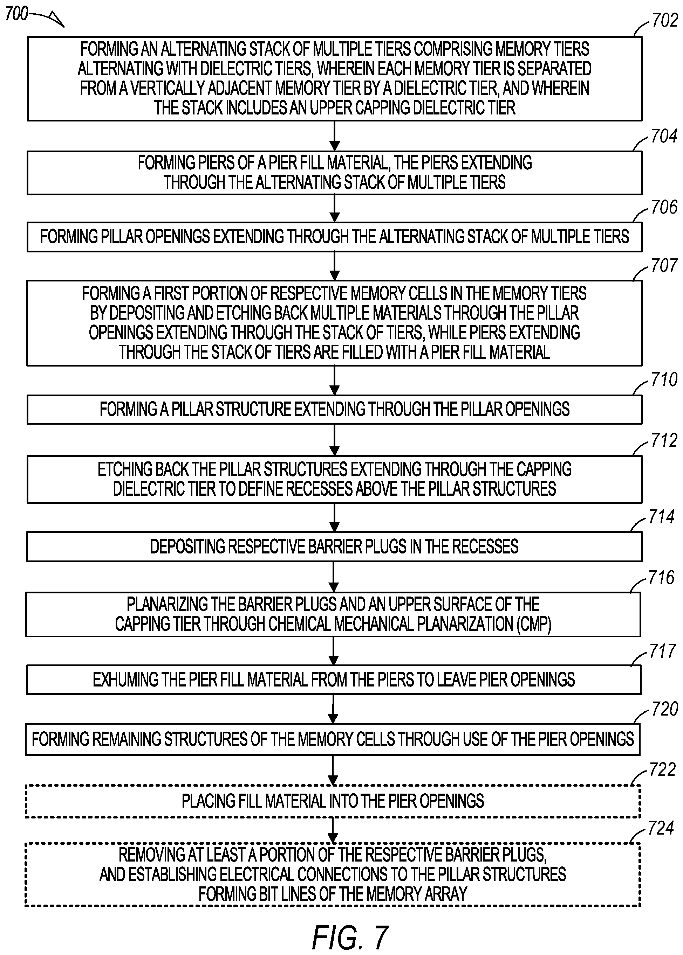

Referring now to Figure 7, the figure depicts an example flow chart of a method 700 for forming a memory structure in accordance with the description herein. As indicated in 702, the process stops with forming an alternating stack of multiple tiers comprising memory tiers alternating dielectric tiers wherein each memory tier is separated from vertically adjacent memory tier by a dielectric tier, and wherein the stack includes an upper capping dielectric tier. The stack may be, for example, generally as described relative to Figures 3A-3B. As indicated 704 the method includes forming piers of a pier fill material, the piers extending through the alternating stack of multiple tiers. As described herein the piers may either be of a single material or may have multiple components, for example a liner material and a primary fill material.

After the piers have been formed, as indicated at 706, the method includes forming people are openings extending through the alternating stack of multiple tiers. As described above, and as indicated at 708 a first portion of the memory cells of the memory structure will be performed through the pillar openings; both etching and depositing material. As described herein, in the present example involving a replacement gate methodology, forming of the first portion of the memory cells includes exhuming the original placeholder material of the stacked tier structure through the pillar openings, and subsequently depositing word line material the pillar openings. Subsequently additional structures of the memory cells are formed.

As indicated at 710, after forming the first portion of the respective memory cells, a pillar structure is formed extending through the pillar openings the pillar structure will include a conductive pillar, for example formed of tungsten, and may include a liner or other material extending with the conductive pillar.

As indicated 712 the method includes etching back the pillar structures extending through the capping dielectric tier to define recesses above the pillar structures. In some examples, the pillar structures may be etched back to approximately the bottom surface of the capping dielectric tier. As indicated 714, respective barrier plugs are deposited in the recesses. As indicated 716, the method includes planarizing the barrier plugs and an upper surface of the capping tier through chemical mechanical planarization (CMP).

As indicated at 718, the method that includes exhuming the pier fill material from the piers to leave pier openings. With the pier is exhumed, the method proceeds to form remaining structures of the memory cells through use of the pier openings, as indicated at 720.

In selected examples the method may optionally include again placing fill material into the pier openings as indicated at 722. In some examples, the exhumed piers may be replaced with the same material as was previously in the pier. In other examples, the fill material in the exhumed piers will be different from that previously placed, with the result that a first portion of the piers of the memory array will be formed of a first material, and a second portion of the piers of the memory array will be formed of a second material.

Additionally, in selected examples, as indicated in 724, the method optionally includes removing at least a portion of the respective barrier plugs and establishing electrical connections to the pillar structures forming bit lines of the memory array. In selected examples, such electrical connections may be connecting the bit lines to additional circuitry, such as, for example sensing circuitry 530.

In the present example, the need for the new methodology described herein results from the process flow in which a portion of the memory cells are constructed first through use of pillar openings which are then filled with pillars that form a structure of the finished memory array; and the memory cells are completed by exhuming another set of openings, as described, pier openings, to access the memory cell structures in each memory tier to complete the memory cells. Another consideration is the pillar material is tungsten, which is susceptible to etch processes to remove other materials (in the present case the pier material); and to do so in a circumstance in which use of a complete hard mask is challenging. In other process flows, the need may to remove a material other than a pier, while leaving another structure, for example a conductive structure, in place. As will be apparent to persons skilled in the art having the benefit of this disclosure, the methodology described herein the described techniques may be used in those other instances, and the adaptation for such uses is expressly envisioned.

The above Detailed Description includes references to the accompanying drawings, which form a part of the Detailed Description. The drawings show, by way of illustration, specific embodiments in which the invention can be practiced. These embodiments are also referred to herein as "examples". Such examples can include elements in addition to those shown or described. However, the present inventor also contemplates examples in which only those elements shown or described are provided. Moreover, the present inventor also contemplates examples using any combination or permutation of those elements shown or described (or one or more aspects thereof), either with respect to a particular example (or one or more aspects thereof), or with respect to other examples (or one or more aspects thereof) shown or described herein.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein". Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

The term "horizontal" as used in this document is defined as a plane parallel to the conventional plane or surface of a substrate, such as that underlying a wafer or die, regardless of the actual orientation of the substrate at any point in time. The term "vertical" refers to a direction perpendicular to the horizontal as defined above. Prepositions, such as "on," "over," and "under" are defined with respect to the conventional plane or surface being on the top or exposed surface of the substrate, regardless of the orientation of the substrate; and while "on" is intended to suggest a direct contact of one structure relative to another structure which it lies "on"(in the absence of an express indication to the contrary); the terms "over" and "under" are expressly intended to identify a relative placement of structures (or layers, features, etc.), which expressly includes--but is not limited to--direct contact between the identified structures unless specifically identified as such. Similarly, the terms "over" and "under" are not limited to horizontal orientations, as a structure may be "over" a referenced structure if it is, at some point in time, an outermost portion of the construction under discussion, even if such structure extends vertically relative to the referenced structure, rather than in a horizontal orientation.

The terms "wafer" and "substrate" are used herein to refer generally to any structure on which integrated circuits are formed, and also to such structures during various stages of integrated circuit fabrication. The following Detailed Description is, therefore, not to be taken in a limiting sense, and the scope of the various embodiments is defined only by the appended claims, along with the full scope of equivalents to which such claims are entitled.

Various embodiments according to the present disclosure and described herein include memory utilizing a vertical structure of memory cells. As used herein, directional adjectives will be taken relative a surface of a substrate upon which the memory cells are formed (i.e., a vertical structure will be taken as extending away from the substrate surface, a bottom end of the vertical structure will be taken as the end nearest the substrate surface and a top end of the vertical structure will be taken as the end farthest from the substrate surface).

As used herein, directional adjectives, such as horizontal, vertical, normal, parallel, perpendicular, etc., can refer to relative orientations, and are not intended to require strict adherence to specific geometric properties, unless otherwise noted. For example, as used herein, a vertical structure need not be strictly perpendicular to a surface of a substrate, but may instead be generally perpendicular to the surface of the substrate, and may form an acute angle with the surface of the substrate (e.g., between 60 and 120 degrees, etc.).

Operating a memory cell, as used herein, includes reading from, writing to, or erasing the memory cell. The operation of placing a memory cell in an intended state is referred to herein as "programming," and can include both writing to or erasing from the memory cell (i.e., the memory cell may be programmed to an erased state).

It will be understood that when an element is referred to as being "on," "connected to" or "coupled with" another element, it can be directly on, connected, or coupled with the other element or intervening elements may be present. In contrast, when an element is referred to as being "directly on," "directly connected to" or "directly coupled with" another element, there are no intervening elements or layers present. If two elements are shown in the drawings with a line connecting them, the two elements can be either be coupled, or directly coupled, unless otherwise indicated.

To better illustrate the method and apparatuses disclosed herein, a non-limiting list of examples is provided:

Example 1 is a method of forming a memory array, comprising: forming an alternating stack of multiple tiers comprising memory tiers alternating with dielectric tiers, wherein each memory tier is separated from a vertically adjacent memory tier by a dielectric tier, and wherein the stack includes an upper capping dielectric tier; forming piers of a pier fill material, the piers extending through the alternating stack of multiple tiers; forming pillar openings extending through the alternating stack of multiple tiers; forming first portions of respective memory cells in the memory tiers by depositing and etching back multiple materials through the pillar openings extending through the stack of tiers, while piers extending through the stack of tiers are filled with a respective pier fill material; forming a pillar structure extending through the pillar openings; etching back the pillar structures extending through the capping dielectric tier to define recesses above the pillar structures; depositing respective barrier plugs in the recesses above the pillar structures; planarizing the barrier plugs and an upper surface of the capping tier through chemical mechanical planarization (CMP); exhuming the pier fill material from at least selected piers to leave pier openings; and forming remaining structures of the memory cells through use of the pier openings.

In Example 2, the subject matter of Example 1 optionally includes after forming the remaining structures of the memory cells through use of the pier openings to complete the memory structures of the memory array, placing fill material into the pier openings.

In Example 3, the subject matter of any one or more of Examples 1-2 wherein forming first portions of respective memory cells in the memory tiers comprises forming first and second electrodes of respective memory cells, the first and second electrodes of a respective memory cell spaced from one another by a placeholder material.

In Example 4, the subject matter of Example 3 wherein the first and second electrodes of respective memory cells comprise carbon.

In Example 5, the subject matter of any one or more of Examples 1-4 optionally include before forming first portions of respective memory cells, forming word lines extending in a word line direction within respective memory tiers.

In Example 6, the subject matter of any one or more of Examples 1-5 wherein the pillar structures comprise a conductive material, configured to serve as portions of respective bit lines coupled to multiple vertically arranged memory cells.

In Example 7, the subject matter of any one or more of Examples 3-6 wherein the pillar structures comprise tungsten.

In Example 8, the subject matter of any one or more of Examples 5-7 wherein the pillar structures comprise titanium nitride liner surrounding the tungsten.

In Example 9, the subject matter of any one or more of Examples 1-8 optionally include removing at least a portion of the respective barrier plugs, and establishing electrical connections to the pillar structures forming bit lines of the memory array.

In Example 10, the subject matter of Example 9 wherein the electrical connections to the pillar structures are established below the chemical mechanical planarized upper surface of the capping tier.

In Example 11, the subject matter of any one or more of Examples 1-10 wherein exhuming the pier fill material from at least selected piers to leave pier openings comprises exhuming the pier fill material from a first group of piers, while leaving the pier fill material in a second group of piers intact.

In Example 12, the subject matter of Example 11 wherein piers of the first group of piers alternate along the word line direction with piers of the second group of piers.

In Example 13, the subject matter of any one or more of Examples 3-12 wherein forming remaining structures of the memory cells through use of the pier openings comprises, removing at least a portion of the placeholder material spacing the first and second electrodes; and placing a variable state material between the first and second electrodes.

Example 14 is an array of memory cells, comprising: a stack of spaced memory tiers, respectively containing multiple cross-point memory cells, and alternating dielectric tiers between the memory tiers, the stack of spaced memory tiers and dielectric tiers topped by at least one capping tier; multiple word lines which extend along a first direction to respective first pluralities of memory cells in respective memory tiers; and multiple bit lines which include conductive pillars which extend at least in part generally vertically and extend to respective second pluralities of memory cells distributed across multiple memory tiers, wherein upper ends of the generally vertically extending conductive pillars terminate beneath the at least one capping tier, and circuit connections with the respective conductive pillars are made at an interface of the at least one capping tier with a remaining portion of the stack of spaced memory tiers and dielectric tiers.

In Example 15, the subject matter of Example 14 wherein the array further includes multiple piers, wherein at least a first portion of the multiple piers extend through the stack of spaced memory and dielectric tiers and to the top of the capping tier.

In Example 16, the subject matter of Example 15 wherein all piers of the array extend through the stack of spaced memory and dielectric tiers and into the capping tier.

In Example 17, the subject matter of any one or more of Examples 14-16 wherein a first portion of the multiple piers comprise a first pier material.

In Example 18, the subject matter of Example 17 wherein a second portion of the multiple piers comprise a second pier material different from the first pier material.

In Example 19, the subject matter of any one or more of Examples 17-18 wherein piers of the second portion of the multiple piers alternate with piers of the first portion of the multiple piers along the first direction.

In Example 20, the subject matter of any one or more of Examples 14-19 wherein electrical connections directly to the pillars occurs at a level below the top of the capping tier.

Example 21 is a method of forming a memory structure, comprising: forming a multi-tier structure, wherein multiple tiers within the structure contain memory cells, wherein forming the memory cells in the multiple tiers comprises, accessing the multiple tiers through a first vertical opening; filling the first vertical opening with a first material which will remain in the completed memory structure; forming a barrier plug in a capping tier extending over the multi-tier structure, the barrier plug extending above the first vertical opening; etching material at a second location to open a second vertical opening, using the barrier plug to prevent etching of the first material; and subsequently accessing the multiple tiers through the second vertical opening.

In Example 22, the subject matter of Example 21 wherein accessing the multiple tiers through the first vertical opening comprises forming a first portion of respective memory cells in the multiple tiers; and wherein said accessing the multiple tiers to the second vertical opening comprises forming a second portion of respective memory cells in the memory tiers.

In Example 23, the subject matter of any one or more of Examples 21-22 wherein etching material at the second location to open a second vertical opening comprises removing a placeholder material from a previously formed opening.

In Example 24, the method of claim 11 may be used to make semiconductor structures other than memory devices.

The above description is intended to be illustrative, and not restrictive. For example, the above-described examples (or one or more aspects thereof) may be used in combination with each other. Other embodiments can be used, such as by one of ordinary skill in the art upon reviewing the above description. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description, with each claim standing on its own as a separate embodiment, and it is contemplated that such embodiments can be combined with each other in various combinations or permutations. The scope of the invention is defined by the appended claims.

## Claims

1. A method of forming a memory array, comprising:
forming an alternating stack of multiple tiers comprising memory tiers alternating with dielectric tiers, wherein each memory tier is separated from a vertically adjacent memory tier by a dielectric tier, and wherein the stack includes an upper capping dielectric tier;
forming piers of a pier fill material, the piers extending through the alternating stack of multiple tiers;
forming pillar openings extending through the alternating stack of multiple tiers;
forming first portions of respective memory cells in the memory tiers by depositing and etching back multiple materials through the pillar openings extending through the stack of tiers, while piers extending through the stack of tiers are filled with a respective pier fill material;
forming a pillar structure extending through the pillar openings;
etching back the pillar structures extending through the capping dielectric tier to define recesses above the pillar structures;
depositing respective barrier plugs in the recesses above the pillar structures;
planarizing the barrier plugs and an upper surface of the capping tier through chemical mechanical planarization (CMP);
exhuming the pier fill material from at least selected piers to leave pier openings; and
forming remaining structures of the memory cells through use of the pier openings.

2. The method of forming a memory array of claim 1, further comprising, after forming the remaining structures of the memory cells through use of the pier openings to complete the memory structures of the memory array, placing fill material into the pier openings.

3. The method of forming a memory array of any preceding claim, wherein forming first portions of respective memory cells in the memory tiers comprises forming first and second electrodes of respective memory cells, the first and second electrodes of a respective memory cell spaced from one another by a placeholder material, and optionally wherein the first and second electrodes of respective memory cells comprise carbon.

4. The method of forming a memory array according to any preceding claim, further comprising, before forming first portions of respective memory cells, forming word lines extending in a word line direction within respective memory tiers.

5. The method of forming a memory array of any preceding claim, wherein the pillar structures comprise a conductive material, configured to serve as portions of respective bit lines coupled to multiple vertically arranged memory cells.

6. The method of forming a memory array of claim 3, wherein the pillar structures comprise tungsten and optionally wherein the pillar structures comprise titanium nitride liner surrounding the tungsten.

7. The method of forming a memory array of any preceding claim, further comprising removing at least a portion of the respective barrier plugs, and establishing electrical connections to the pillar structures forming bit lines of the memory array and optionally wherein the electrical connections to the pillar structures are established below the chemical mechanical planarized upper surface of the capping tier.

8. The method of forming a memory array of any preceding claims, wherein exhuming the pier fill material from at least selected piers to leave pier openings comprises exhuming the pier fill material from a first group of piers, while leaving the pier fill material in a second group of piers intact and optionally wherein piers of the first group of piers alternate along a word line direction with piers of the second group of piers.

9. The method of forming a memory array of claim 3, wherein forming remaining structures of the memory cells through use of the pier openings comprises,
removing at least a portion of the placeholder material spacing the first and second electrodes; and
placing a variable state material between the first and second electrodes.

10. An array of memory cells, comprising:
a stack of spaced memory tiers, respectively containing multiple cross-point memory cells, and alternating dielectric tiers between the memory tiers, the stack of spaced memory tiers and dielectric tiers topped by at least one capping tier;
multiple word lines which extend along a first direction to respective first pluralities of memory cells in respective memory tiers; and
multiple bit lines which include conductive pillars which extend at least in part generally vertically and extend to respective second pluralities of memory cells distributed across multiple memory tiers,
wherein upper ends of the generally vertically extending conductive pillars terminate beneath the at least one capping tier, and circuit connections with the respective conductive pillars are made at an interface of the at least one capping tier with a remaining portion of the stack of spaced memory tiers and dielectric tiers.

11. The array of memory cells of claim 10, wherein the array further includes multiple piers, wherein at least a first portion of the multiple piers extend through the stack of spaced memory and dielectric tiers and to the top of the capping tier.

12. The array of memory cells of claim 11, wherein all piers of the array extend through the stack of spaced memory and dielectric tiers and into the capping tier.

13. The array of memory cells of claim 11, wherein the first portion of the multiple piers comprise a first pier material.

14. The array of memory cells of claim 13, wherein a second portion of the multiple piers comprise a second pier material different from the first pier material and optionally wherein piers of the second portion of the multiple piers alternate with piers of the first portion of the multiple piers along the first direction.

15. The array of memory cells of any of claims 10 to 14, wherein electrical connections directly to the pillars occurs at a level below the top of the capping tier.
